(19) Europäisches Patentamt
European Patent Office
Office européen des brevets

(11) **EP 1 574 874 B1**

(12) **EUROPÄISCHE PATENTSCHRIFT**

(45) Veröffentlichungstag und Bekanntmachung des Hinweises auf die Patenterteilung:
**13.02.2008 Patentblatt 2008/07**

(51) Int Cl.:
***G01R 33/485*** *(2006.01)*

(21) Anmeldenummer: **05004415.5**

(22) Anmeldetag: **01.03.2005**

(54) **Verfahren zur Messung der Magnetresonanz (NMR) von Substanzen mit hyperpolarisierten Kernen mittels Continuously Refocused Multiecho Spectroscopic Imaging**

Methods of measuring hyperpolarized substances by NMR using Continuously Refocused Multiecho Spectroscopic Imaging

Méthodes de mesure de substances hyperpolarisées par RMN en utilisant Continuously Refocused Multiecho Spectroscopic Imaging

(84) Benannte Vertragsstaaten:
**AT CH GB LI**

(30) Priorität: **11.03.2004 DE 102004011874**

(43) Veröffentlichungstag der Anmeldung:
**14.09.2005 Patentblatt 2005/37**

(73) Patentinhaber: **Universitätsklinikum Freiburg**
**78106 Freiburg (DE)**

(72) Erfinder: **Hennig, Jürgen, Prof. Dr.**
**79100 Freiburg (DE)**

(74) Vertreter: **Kohler Schmid Möbus**
**Patentanwälte**
**Ruppmannstrasse 27**
**70565 Stuttgart (DE)**

(56) Entgegenhaltungen:
**US-A- 4 896 113       US-A- 5 779 636**

- **W. DREHER, D. LEIBFRITZ: "A NEW METHOD FOR FAST PROTON SPECTROSCOPIC IMAGING: SPECTROSCOPIC GRASE" MAGNETIC RESONANCE IN MEDICINE, Bd. 44, November 2000 (2000-11), Seiten 668-672, XP000969761 ISSN: 0740-3194**
- **K. OSHIO, D.A. FEINBERG: "SINGLE-SHOT GRASE IMAGING WITHOUT FAST GRADIENTS" MAGNETIC RESONANCE IN MEDICINE, Bd. 26, 1. August 1992 (1992-08-01), Seiten 355-360, XP000294183 ISSN: 0740-3194**

**Beschreibung**

Die Erfindung betrifft ein Verfahren der Kernspinresonanz (=NMR) zur ortsaufgelösten Messung der Verteilung von Signalen von Metaboliten unterschiedlicher Resonanzfrequenz durch Anwendung einer Folge von Hochfrequenzpulsen und geschalteten Magnetfeldern, wobei die erzeugten Signale durch Anwendung von Lesegradienten in Richtung dieses Gradienten ortskodiert erzeugt werden, wobei die initial angeregte Magnetisierung nach einem Zeitintervall TR/2 einer im Abstand TR äquidistanten Folge von mehreren Hochfrequenzpulsen unterworfen wird und die eingesetzten Magnetfeldgradienten in jedem TR-Interval so angewendet werden, dass die ursprünglich angeregte Magnetisierung in mehreren TR-Intervallen immer wieder refokussiert wird und damit mehrfach zur Auslesung gelangt, wobei auch innerhalb eines TR-Intervalls durch mehrfache Inversion des Lesegradienten mehrere Signale erzeugt werden, und wobei die mehrfach ausgelesenen Signale durch die Anwendung von Phasenkodiergradienten jeweils identisch ortskodiert werden und sich daher nur bezüglich der durch die jeweilige Resonanzfrequenz gegebene Dephasierung unterscheiden, so dass die Einzelsignale zu jeder Auslesezeit anschließend den Signalbeiträgen der untersuchten Substanzen unterschiedlicher Resonanzfrequenz zugeordnet werden können.

Ein NMR-Verfahren, bei dem refokussierte Signale durch Anwendung einer periodischen Folge von Pulsen im Abstand TR nach einem Anregungspuls erzeugt werden, wobei alle Signale innerhalb TR die gleiche Ortskodierung, aber unterschiedlicher chemical shift-Kodierung erhalten, ist aus (10) bekannt.

Hintergrund der Erfindung

In den letzten Jahren wurden eine Reihe von Techniken entwickelt, welche es erlauben, Kerne mit magnetischem Moment so zu präparieren, dass die Population der einzelnen Kernspin-Zustände z.T. erheblich von dem durch die Boltzmann Verteilung gegebenen Gleichgewichtszustand abweicht (12). Die damit verbundene geänderte Populationsdifferenz lässt sich in einem NMR-Experiment in eine erhebliche Steigerung der Signalintensität um Faktoren von bis zu mehreren Tausend umsetzen (sogenannte Hyperpolarisation'). Bekannte Verfahren, eine solche Hyperpolarisation zu erreichen beruhen z.B. auf der über optische Übergänge vermittelte Hyperpolarisation von Edelgasen (12), Polarisation vermittelt über Elektronenspin-Übergänge geeigneter Radikale (Dynamic Nuclear Polarisation=DNP) (11), über chemische Reaktionen mit Spin-geordneten Substanzen (Para-Hydrogene Polarization=PHP) (11) oder auch thermische Polarisation bei extrem tiefen Temperaturen in extrem hohen Magnetfeldern (12). Vor allem die 3 letztgenannten Verfahren sind dabei insofern besonders vielversprechend, da sie eine Polarisation einer großen Anzahl von auch medizinisch-biologisch relevanten Substanzen erlauben.

Auf Grund der Abweichung der Populationsdifferenzen vom Gleichgewichtszustand ist die Lebensdauer der gebildeten Hyperpolarisation begrenzt, das polarisierte Spinsystem wird sich mit der Relaxationskonstante T1 in das thermische Gleichgewicht relaxieren. Daher werden für entsprechende Experimente bevorzugt Substanzen mit langen T1-Konstanten eingesetzt. Entsprechende Experimente wurden daher zunächst mit Edelgasen durchgeführt, welche sich zum einen leicht polarisieren lassen und die über sehr lange T1-Zeiten verfügen. In jüngster Zeit wurden vor allem mit DNP- und PHP-Hyperpolarisation Substanzen mit C13-markierten Kernen an geeigneten Bindungsstellen eingesetzt, wobei die angesprochenen Prinzipien der Hyperpolarisation durchaus auch auf andere Kerne Anwendung finden können.

Zur Messung der NMR-Signale solcher Substanzen ist zu beachten, dass die einmal präparierte Magnetisierung, welche ursprünglich als z-Magnetisierung vorliegt, zur Signalauslesung in transversale Magnetisierung überführt werden muss und dann mit der im allgemeinen wesentlich schnelleren transversalen Relaxationszeit T2 in den Gleichgewichtszustand zerfällt. Eine durch einen 90°-Puls angeregte Magnetisierung steht damit anschaulich betrachtet nur einmalig zum Auslesen zur Verfügung, so dass viele der herkömmlichen Messverfahren der NMR-Spektroskopie oder auch der MR-Bildgebung für die Anwendung an hyperpolarisierten Substanzen nicht geeignet sind. Für bildgebende Experimente mit entsprechenden Substanzen werden daher entweder sogenannte Gradientenechosequenzen mit kleinen Flipwinkeln verwendet, bei welchen bei jeder Anregung nur ein sehr geringer Teil der polarisierten Magnetisierung ausgelesen wird. In neuerer Zeit und insbesondere bei 13C-polarisierten Substanzen wurden auch modifizierte steady state-Sequenzen verwendet, welche bei Verwendung großer Flipwinkel (180°) nach einem initialen 90°-Puls über Spin-Echo Bildung ein mehrfaches Auslesen der Hyperpolarisation erlauben und damit eine maximale Signalausbeute liefern.

Ein besonders interessantes und vielversprechendes Anwendungsgebiet der Hyperpolarisations-Messung stellt die Beobachtung des metabolischen Umsatzes polarisierter Substanzen dar. So lässt sich z.B. zeigen, dass nach venöser Injektion von Pyruvat ein metabolischer Umsatz nach Laktat und Alanin stattfindet. Über die Messung des Laktat-Signals lässt sich daher die lokale metabolische Rate bestimmen, ein Parameter, welcher insbesondere in der Krebsdiagnostik von großer Bedeutung ist.

Voraussetzung der Messung ist es hierbei eine getrennte Messung der Signale von Laktat, Alanin und Pyruvat, wobei bevorzugt Bilder entsprechend der räumlichen Verteilung der Metabolite erstellt werden sollen. Nach dem Stand der Technik lässt sich eine solche Darstellung der räumlichen Verteilung von Metaboliten mittels sogenannter Chemical Shift Imaging (CSI)-Techniken erreichen. Ein Problem solcher Techniken ist es allerdings, dass sie eine erhebliche Verlängerung der Messzeit mit sich bringen: Zur Aufnahme eines nicht chemical-shift kodierten Bildes einer Matrixgröße von n1 x n2 Bildelementen (Pixeln) genügen n2 Aufnahmeschritte, da sich die 1.Dimension eines Bildes bei Signalauslesung unter Verwendung eines Ortskodiergradienten in einem Aufnahmeschritt durchführen lässt. Bei einem CSI-Experiment mit Aufnahme von s1 Punkten in Richtung der spektroskopischen Dimension sind hingegen n2 x s1 Aufnahmeschritte notwendig, wobei s1 im allgemeinen im Bereich 8 < s1 < 128 liegt. Die Gesamtzahl der Aufnahmeschritte wächst damit um einen Faktor s1, bei einer durch die Lebensdauer der polarisierten Spins begrenzten Anzahl der Aufnahmeschritte wird die räumliche Auflösung entsprechend um einen Faktor s1 reduziert.

Als Alternative zu einem CSI-Experiment lassen sich Verfahren des chemical shift selective imaging (CSSI) durchführen, bei welchen eine Selektion bezüglich der chemischen Verschiebung durch entsprechende chemical shift selektive Präparation entweder der Signalphase oder der Signalamplitude erzielen lässt und die Aufnahme der Signale dann mittels herkömmlichern Bildgebungssequenzen erfolgt. Das am häufigsten verwendete Verfahren des CHESS-Imaging ist für die erfindungsgemäße Aufgabe allerdings nicht geeignet, da hierbei das Signal eines der betroffen Metaboliten unterdrückt wird und nur der zweite zur Auslesung gelangt, während ein mapping des metabolischen Umsatzes immer die Aufnahme beider (oder auch mehrerer) Metaboliten verlangt.

Detaillierte Beschreibung der erfindungsgemäßen Methode

Aufgabe der vorliegenden Erfindung ist es demgegenüber, ein Verfahren mit den eingangs beschriebenen Merkmalen auf möglichst einfache Weise so zu modifizieren, dass sich damit eine chemical shift selektive Messung hyperpolarisierter Metaboliten durchführen lässt.

Erfindungsgemäß wird diese Aufgabe dadurch gelöst, dass die untersuchten Spins in einem hyperpolarisierten Zustand weit weg von der Gleichgewichtsmagnetisierung präpariert und können daher nur einmalig zur Anregung verwendet werden, und dass die Gradienten so angewendet werden, dass alle Gradientenintegrale zwischen aufeinander folgenden HF-Pulsen null sind und damit eine vollständige Refokussierung eintritt, wobei die HF-Pulse Flipwinkel nahe 180° aufweisen, wodurch eine vollständige Refokussierung eintritt.

Zum einen werden Aufnahmeverfahren angewendet, bei welchen Messsequenzen angewendet werden, bei welchen eine einmalig angeregte Magnetisierung durch Anwendung entsprechender Refokussierungspulse und Magnetfeldgradienten mehrfach zur Auslesung unter Ortskodierung mittels Magnetfeldgradienten gebracht wird.

In jedem Refokussierungsintervall (= Zeit zwischen 2 Hochfrequenzpulsen) werden mehrere Signale ausgelesen, welche in Bezug auf die durch Magnetfeldgradienten bewirkte Ortskodierung identisch kodiert sind, wobei sich die Signale unterschiedlicher Metaboliten jeweils durch einen charakteristischen Verlauf der jeweiligen Signalphase unterscheiden und sich die Einzelsignale der beobachteten Metaboliten über entsprechende Algorithmen voneinander trennen lassen.

Der Bezug dieses erfindungsgemäßen Verfahrens zum Stand der Technik ergibt sich wie folgt:

Bezüglich der Signalerzeugung werden Sequenzen verwendet, welche als SSFP-Sequenz (1), Multiecho-SSFP-Sequenz (2), GRASE-Sequenz (3) bekannt sind. Das Konzept der Kodierung der chemischen Verschiebung über ein mehrfaches Auslesen der Signale durch mehrfache Gradientenumkehr ist in (4) für viele Signale mit nachfolgender Separation durch Fouriertransformation beschrieben, (5) beschreibt, wie Signale zu unterschiedlichen Auslesezeiten durch Lösung eines entsprechenden lineare Gleichungssystems separiert werden können. Schließlich zeigt (6) das Grundprinzip einer unipolaren Auslesung und (7) bis (9) Varianten der Signalerzeugung zur Optimierung der Signalausbeute durch Variation der Flipwinkel.

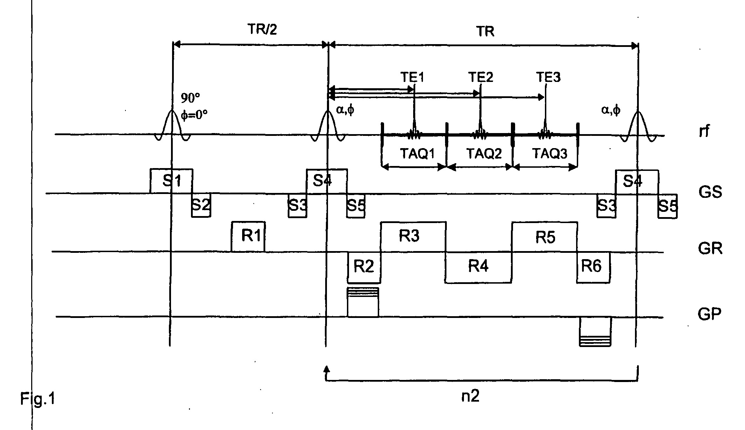

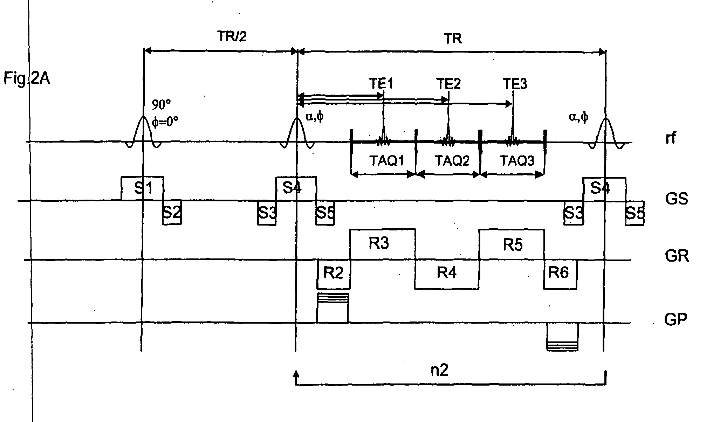

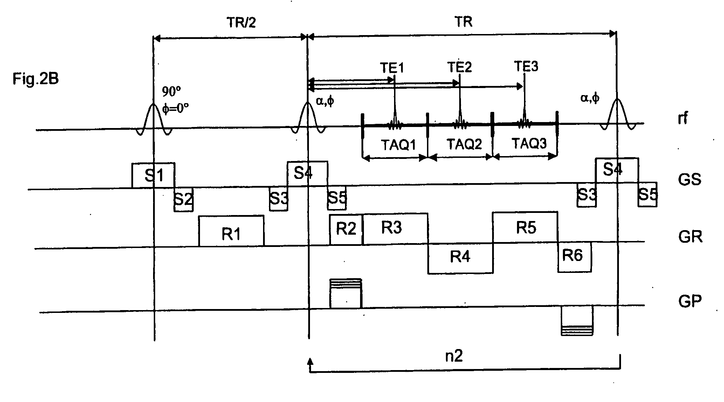

Das Grundschema der sich aus Kombination dieser Merkmale ergebenden Sequenz ist in Fig.1 dargestellt. Dabei kennzeichnet RF die Hochfrequenzpulse und Signale, GS den Schichtselektionsgradient, GR den Lesegradient und GP den Phasenkodiergradient. Die Auswahl des jeweils zur Signalgebung selektierten Spinensembles erfolgt durch entsprechende Wahl der einzelnen Gradientenpulse. Für R1=0 und R2+R3+R4+R5+R6=0 sowie vollständiger Rephasierung der entsprechenden Schichtgradienten ergibt sich eine vollständig refokussierte (VR)-Sequenz bezüglich des Gradientenschemas (Fig.2A). Wenn alle Flipwinkel der im zeitlichen Abstand TR wiederholten Messsequenz nahe 180° sind, wir die gesamte Magnetisierung dabei als transversale Magnetisierung vorliegen und entsprechend refokussiert werden. Für R1=R3, R2=R3/2 und R2+R3+R4+R5+R6=2R1 mit entsprechenden Schichtselektionsgradienten ergibt sich eine Spin-echo-(SE)-Sequenz (Fig.2B), bei welcher sich mit $\alpha \sim$ 180° ebenfalls vor allem transversale Magnetisierung bildet und als Spin-Echo ausgelesen werden kann. Vor allem bei Anwendung an Substanzen mit T2<<Tl ist dies besonders günstige, da damit der Signalzerfall entsprechend langsamer erfolgt. Unterschiede zwischen der VR- und der SE-Sequenz ergeben sich dadurch, dass die SE-Sequenz eine vollständige Refokussierung aller Spins bewirkt, wohingegen bei der VR-Sequenz eine Signalabschwächung entsprechend der Off-Resonanzfrequenz auftreten kann. Bezüglich der Phasen der Hochfrequenzimpulse wird die Phase $\phi$ für die VR-Sequenz in aufeinanderfolgenden TR-Intervallen zwischen 180° und 0° alterniert, für die SE-Sequenz wird entweder eine Phasenalternierung angewendet oder eine Phase von durchgängig 90° entsprechend der CPMG-Bedingung verwendet. Durch Variation der Flipwinkel $\alpha$ entsprechend den in der Literatur bekannten Prinzipien für das Hyperecho- oder TRAPS-Verfahren (im Falle SE-Sequenz) bzw.

das TIDE-Verfahren (im Falle VR-Sequenz) wird ein gewisser Anteil der Magnetisierung als z-Magnetisierung vorliegen und entsprechend der Relaxationszeit T1, d.h. im allgemeinen langsamer als bei reinem transversalen Zerfall, relaxieren.

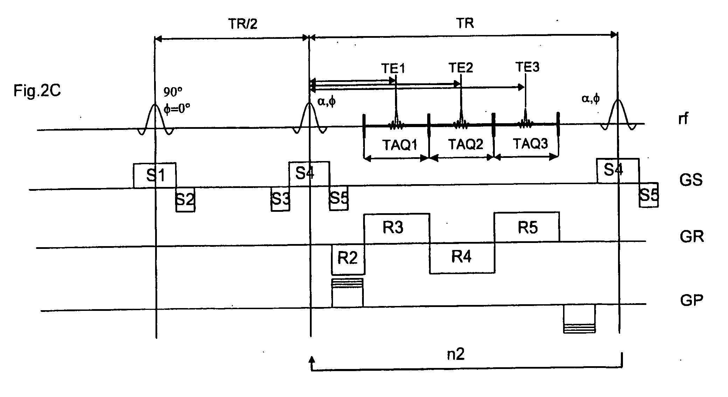

Entsprechend dem bekannten Verhalten der Spins für refokussierte Sequenzen werden die Signale aller Spins unabhängig von ihrer jeweiligen Resonanzfrequenz zum Zeitpunkt $TE_0=TR/2$ zumindest annähernd mit identischer Signalphase vorliegen, im Falle der SE-Sequenz ist die Refokussierung sogar vollständig. Es ist daher bevorzugt, wenn auch nicht zwingend notwendig, das Auslesen eines der gebildeten Signale auf diesen Zeitpunkt zu legen, in den Figuren 1 und 2 also TE2=TR/2 zu wählen.

Als dritte Variante lässt sich schließlich noch eine Sequenz realisieren, bei welcher R1 und R2+R3+R4+R5+R6 beliebige Werte annehmen. Soweit eine solche Sequenz in einem periodischen Schema angewandt wird, tritt dabei durch sogenanntes Even-Echo-Refocussing eine jeweils identische Refokussierung in jeder 2.Wiederholungsperiode ein (EE-Sequenz). Der nominelle Zeitpunkt der vollständigen Kohärenz ist dann durch den Zeitpunkt gegeben, bei welchem die durch R1 bedingte Dephasierung durch R2 od. R3 wieder refokussiert ist.

In einer bevorzugten Realisierung wird dabei R1=R6=0 und R2=R3/2 gesetzt (Fig.2C). Der Zeitpunkt der vollständigen Signalkohärenz ist dann $TE_0=0$. Durch Erhöhung der Amplitude von R4 kann das Zeitintervall der Phasenumkehr dabei zur Effizienzsteigerung reduziert werden.

Bei allen unterschiedlichen Varianten der Signalerzeugung dephasieren Spins unterschiedlicher Metabolite in der Zeit zwischen 2 RF-Pulsen entsprechend ihrer jeweiligen Resonanzfrequenz ω. Sie erfahren daher eine kontinuierliche Entwicklung ihrer jeweiligen Phase entsprechend ω. Durch Gradientenumkehr gelangen diese Signale entsprechend dem Prinzip des EPSI-Verfahrens mehrfach innerhalb eines TR-Intervalls zu Auslesung. Bezüglich des Gradienten sind die Signale daher in 2 Gruppen zu jeweils umgekehrter Gradientenpolarität unterteilt. Die in der Literatur bevorzugte Art der Behandlung dieser unterschiedlichen Signale ist die, die Signale zu jeweils positivem und negativem Lesegradient getrennt auszuwerten.

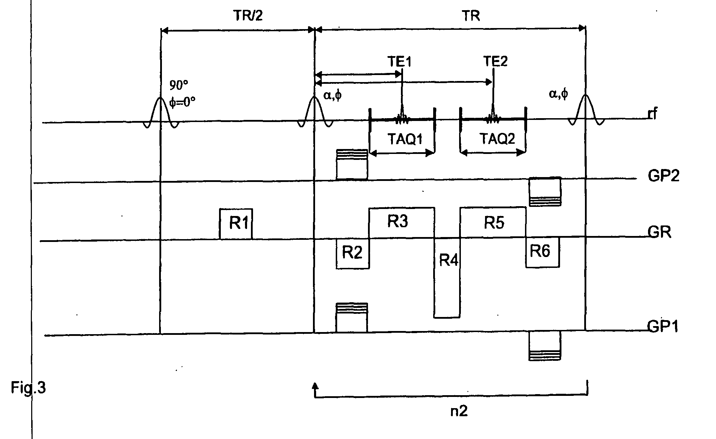

Alternativ dazu lässt sich die Sequenz auch so implementieren, dass Signale nur zu jeweils einer Polarität des Lesegradienten erzeugt werden (Fig.3). Schließlich lassen die Signale zu negativer Gradientenpolarität auch mathematisch durch Umkehr entlang der Zeitachse mit den unter positivem Gradienten aufgenommenen Signalen zur Deckung bringen, wobei hierbei darauf zu achten ist, dass der zeitliche Nullpunkt (=Echozeitpunkt) der beiden Signalgruppen identisch sein muss. Gegebenenfalls müssen die Signale diesbezüglich durch eines der in der Literatur bekannten Verfahren zur EPI-Korrektur korrigiert werden, da ansonsten sogenannte180°-Artefakte auftreten.

Für die Messung von M Substanzen mit unterschiedlicher Frequenz ω1, ω2, ... ωM und jeweils unterschiedlicher Spin dichte ρ1, ρ2.. ρM ergeben sich bei Implementierung mit Signalauslesung zu TE1, TE2,... TEN Auslesezeitpunkten N Signale S1, S2... SN, welche jeweils eine komplexe Überlagerung der entsprechend ω1, ω2, ... ωM phasenmodulierten Einzelsignale darstellen. Für das n-te Signal $S_n$ (mit n aus 1...M) ergibt sich damit

$$S_n = \sum_{m=1}^{M} a_m \rho_m \exp(-i\,\omega(TE_n - TE_0)) \qquad [1]$$

$a_m$ ist dabei ein Abschwächungsfaktor, der die durch T1, T2... oder auch (im Falle der VR-Sequenz) off-resonance bedingte Signalabschwächung jeder Spezies wiedergibt. $TE_0$ ist dabei davon abhängig, ob die VR-, SE- oder EE-Sequenz verwendet wird, für die VR-Sequenz ist $TE_0$ zumindest im Prinzip auch von ω abhängig.

Für die N Signale ergibt sich aus der obigen Gleichung [1] ein lineares Gleichungssystem, welches sich für m<=n entweder explizit (bei bekannten $a_m$ und m=n) oder durch Näherungsverfahren lösen lässt. Die Beiträge ρ1, ρ2.. ρm lassen sich so aus den gemessenen Signalen berechnen. Bei 3 ausgelesenen Signalen entsprechend Fig.1 lassen sich maximal 3 Substanzen mit unterschiedlichen Resonanzfrequenzen unterscheiden. Besonders bevorzugt ist dabei eine Wahl von TE1 und TE3 derart, dass die Signale unterschiedlicher Metabolite zu den Auslesezeitpunkten antiphasig vorliegen. Zur Trennung zweier Metabolite mit den Frequenzen ω0 =0 und ω1 wird dafür das Zeitintervall TE2-TE1 (bzw. TE3-TE2) = 1/(2 ω1) gewählt.

Allgemein lassen sich Signale von n Metaboliten durch Auslesen von n Einzelsignalen in jedem Intervall TR separieren.

Eine alternative Art der Rekonstruktion der Einzelbeiträge ergibt sich vor allem für hinreichend großes N (n>4.. 8) und bei Verwendung äquidistanter Auslesezeitpunkte durch eine Fouriertransformation. Auch bei Trennung von wenigen Metaboliten kann es vorteilhaft sein, mehr als n Signale auszulesen, um die Berechnung der Einzelbeiträge robuster gegen zufällige Signalschwankungen zu machen.

In dem in Fig.1 gezeigten Schema erfolgt eine Ortskodierung in den durch die Richtung von GR und GP definierten Bildebenen unter Schichtselektion mittels GS. Dieses Kodierschema lässt sich in der aus der Literatur an sich bekannten Weise auch durch Anwendung weiterer Phasenkodiergradienten in Richtung GS zu einem Verfahren der drei-dimensionalen chemical shift selektiven Bildgebung erweitern oder auch unter Weglassung von GP als eindimensionale Aufnahme entlang GR durchführen. In allen Fällen kann der Schichtselektionsgradient auch entfallen.

Literatur:

(1) Das Grundschema einer vollständig refokussierten Sequenz ist in Carr HY, Phys.Rev. 112, 1693 (1958)) beschrieben.

(2) Herzka DA, Kellman P, Aletras AH, Guttman MA, McVeigh ER. Multishot EPI-SSFP in the heart. Magn Reson Med 2002;47(4):655-664. zeigt eine Sequenz, in welcher - ähnlich wie bei der VR-Sequenz mehrere Echos in einem TR-Intervall ausgelesen wird, die Sequenz wird allerdings zur Aufnahme nichtchemical shift selektiver Bilder eingesetzt, indem die aufgenommen Echos jeweils unterschiedlich phasenkodiert werden.

(3) Feinberg, D. A., Kiefer, B. et Litt, A. W.: Dual contrast GRASE (gradient-spin echo) imaging using mixed bandwidth, Magnetic Resonance in Medicine 31, 461-464(1994) zeigt analog dazu eine Sequenz ähnlich der SE-Sequenz, wobei auch hier die unterschiedlichen Echos innerhalb einer Refokussierungsperiode zur Beschleunigung der Datenaufnahme eines Bildes verwendet werden

(4) Sarkar S, Heberlein K, Metzger GJ, Zhang X, Hu X. Applications of highresolution echoplanar spectroscopic imaging for structural imaging. J Magn Reson Imaging 1999;10(1):1-7. zeigt eine EPSI-Sequenz, bei welcher nach einer Anregung viele Signale aufgenommen werden und die Signale zu unterschiedlichen Spezies mit unterschiedlicher Resonanzfrequenz durch Fourier-Transformation gewonnen werden.

(5) Reeder SB, Wen Z, Yu H, Pineda AR, Gold GE, Markl M, Pelc NJ. Multicoil Dixon chemical species separation with an iterative least-squares estimation method. Magn Reson Med 2004;51 (1):35-45. zeigt eine Methode, bei welcher Signale zu unterschiedlichem TE sequentiell aufgenommen werden und die Signale der Einzelspezies daraus durch Lösung des sich ergebenden linearen Gleichungssystems gewonnen werden.

(6) Feinberg DA, Turner R, Jakab PD, von Kienlin M. Echo-planar imaging with asymmetric gradient modulation and inner-volume excitation. Magn Reson Med 1990;13(1):162-169. zeigt das Prinzip der Auslesung unter nur jeweils einer Polarität des Lesegradienten.

(7) Hennig J, Weigel M, Scheffler K, Multiecho sequences with variable refocusing Flip Angles: Optimization of Signal Behavior using smooth Transitions between Pseudo Steady States (TRAPS), Magnet Reson Med 49(3): 527-535 (2003)

(8) Hennig J, Speck O, Scheffler K, Optimization of the signal behavior in the transition to driven equilibrium in steady state free precession sequences, Magnet Reson Med 48(5):801-809 (2002)

(9) Hennig J, Scheffler K, Hyperechoes, Magnet Reson Med 46(1):6-12 (2001)

(10) Dreher W, Leibfritz D, A New Method for Fast Proton Spectroscopic Imaging: Spetroscopic GRASE, Magnet Reson Med 44: 668-672 (2000)

(11) Day I J, Wain R, Tozawa T, Smith L J, Hore P J, Photo-CIDNP NMR spectroscopy of a heme-containing protein, Journal of Magnetic Resonance 175:330-335 (2005)

(12) Mansson S, Johansson E, Magnusson P, Chai C-M, Hansson G, Petersson J S, Strahlberg F, Golman K, 13C imaging - a new diagnostic platform, Eur Radiol 16:57-67 (2006)

**Patentansprüche**

1. Verfahren der Kernspinresonanz (=NMR) zur ortsaufgelösten Messung der Verteilung von Signalen von Metaboliten unterschiedlicher Resonanzfrequenz durch Anwendung einer Folge von Hochfrequenzpulsen und geschalteten Magnetfeldern, wobei die erzeugten Signale durch Anwendung von Lesegradienten in Richtung dieses Gradienten ortskodiert erzeugt werden,

wobei die initial angeregte Magnetisierung nach einem Zeitintervall TR/2 einer im Abstand TR äquidistanten Folge von mehreren Hochfrequenzpulsen unterworfen wird und die eingesetzten Magnetfeldgradienten in jedem TR-Intervall so angewendet werden, dass die ursprünglich angeregte Magnetisierung in mehreren TR-Intervallen immer wieder refokussiert wird und damit mehrfach zur Auslesung gelangt,

wobei auch innerhalb eines TR-Intervalls durch mehrfache Inversion des Lesegradienten mehrere Signale erzeugt werden,

und wobei die mehrfach ausgelesenen Signale durch die Anwendung von Phasenkodiergradienten jeweils identisch ortskodiert werden und sich daher nur bezüglich der durch die jeweilige Resonanzfrequenz gegebene Dephasierung unterscheiden, so dass die Einzelsignale zu jeder Auslesezeit anschließend den Signalbeiträgen der untersuchten Substanzen unterschiedlicher Resonanzfrequenz zugeordnet werden können.

**dadurch gekennzeichnet,**

**dass** die untersuchten Spins in einem hyperpolarisierten Zustand weit weg von der Gleichgewichtsmagnetisierung präpariert werden,

und **dass** die Gradienten so angewendet werden, dass alle Gradientenintegrale zwischen aufeinanderfolgenden Hochfrequenzpulsen null sind und dass die Hochfrequenzpulse Flipwinkel nahe 180° aufweisen, wodurch eine vollständige Refokussierung eintritt.

2. Verfahren nach Anspruch 1, **dadurch gekennzeichnet, dass** die Gradientenintegrale zwischen zwei der periodisch im Abstand TR wiederholten Hochfrequenzpulse im Sinne einer Spin-echo- Bildung doppelt so groß sind wie das Integral über die jeweiligen Gradienten zwischen dem Anregungspuls und dem im Abstand TR/2 darauf folgenden ersten Hochfrequenzpulse der periodischen Folge.

3. Verfahren nach einem der vorhergehenden Ansprüche, **dadurch gekennzeichnet, dass** zusätzlich zum Lesegradienten in einer hierzu senkrechten Richtung ein Schichtselektionsgradient angewandt wird, welcher in Verbindung mit einer Ausführung der Hochfrequenzpulse als Schichtselektionspulse zu einer Anregung und Refokussierung der Spins nur eines Teilvolumens führt.

4. Verfahren nach einem der vorhergehenden Ansprüche, **dadurch gekennzeichnet, dass** in einer weiteren Raumrichtung ein Phasenkodiergradient entsprechend der Methode der Bildkodierung nach dem 2-dimensionalen Fourier-Transformationsverfahren angewandt wird.

5. Verfahren nach Anspruch 4, **dadurch gekennzeichnet, dass** zusätzlich in der Richtung des Schichtselektionsgradienten ein weiterer Phasenkodiergradient angewendet wird, welcher zu einer Ortskodierung der Signale entsprechend dem Verfahren der drei-dimensionalen Fouriertransformation führt.

6. Verfahren nach einem der Ansprüche 1 bis 3, **dadurch gekennzeichnet, dass** eine Ortskodierung nach dem Prinzip des Verfahrens der gefilterten Rückprojektion erfolgt.

7. Verfahren nach einem der Ansprüche 1 bis 3, **dadurch gekennzeichnet, dass** eine Ortskodierung nach dem Prinzip des Spiral Imaging erfolgt.

**Claims**

1. Nuclear magnetic resonance (NMR) method for spatially resolved measurement of the distribution of signals of metabolites of different resonance frequencies through application of a sequence of radio frequency pulses and switched magnetic fields, wherein the generated signals are generated in a spatially encoded fashion through application of read gradients in the direction of this gradient, wherein, after a time interval TR/2, the initially excited magnetization is subjected to a sequence of several equidistant RF pulses of intervals TR, and the used magnetic field gradients are applied in each TR interval in such a fashion that the originally excited magnetization is repeatedly refocused in several TR intervals, and is thereby read out several times,

wherein several signals are also generated within one TR interval through multiple inversion of the read gradient, and wherein the repeatedly read-out signals are each identically spatially encoded through application of phase encoding gradients, and therefore differ only with respect to the dephasing given by the respective resonance frequency, such that at any read-out time, the individual signals can subsequently be associated with the signal contributions of the examined substances of different resonance frequencies,

**characterized in that** the investigated spins are prepared in a hyper-polarized state far away from equilibrium magnetization, and the gradients are applied such that all gradient integrals between successive radio frequency pulses are zero and the radio frequency pulses have flip angles close to 180°, whereby complete refocusing occurs.

2. Method according to claim 1, **characterized in that** the gradient integrals between two of the RF pulses, which are periodically repeated at an interval TR, are, in terms of spin-echo formation, twice as large as the integral over the respective gradients between the excitation pulse and the subsequent first RF pulse of the periodic sequence that follows at an interval TR/2 thereto.

3. Method according to any one of the preceding claims, **characterized in that** a slice selection gradient is applied in addition to the read gradient in a direction perpendicular thereto, which causes, in connection with a design of the radio frequency pulses as slice selection pulses, excitation and refocusing of the spins of only a partial volume.

4. Method according to any one of the preceding claims, **characterized in that** a phase encoding gradient is applied in a further spatial direction in correspondence with the image encoding method in accordance with the 2-dimensional Fourier transformation method.

5. Method according to claim 4, **characterized in that** a further phase encoding gradient is additionally applied in the direction of the slice selection gradient, which spatially encodes the signals in correspondence with the three-dimensional Fourier transformation method.

6. Method according to any one of the claims 1 through 3, **characterized in that** spatial encoding is performed according to the principle of the filtered back projection method.

7. Method according to any one of the claims 1 through 3, **characterized in that** spatial encoding is performed according to the spiral imaging principle.

## Revendications

1. Procédé de résonance magnétique nucléaire (=RMN), en vue de la mesure à résolution locale de la répartition de signaux de métabolites de fréquence de résonance différente, par utilisation d'une séquence d'impulsions haute fréquence et de champs magnétiques commutés, les signaux générés étant générés conjointement à un code à résolution locale par utilisation de gradients de lecture en direction de ce gradient,
la magnétisation excitée initialement étant soumise, après un intervalle de temps TR/2, à une séquence de plusieurs impulsions haute fréquence équidistantes de l'écart TR et les gradients de champ magnétique utilisés étant utilisés dans chaque intervalle TR de telle sorte que la magnétisation excitée à l'origine est re-focalisée toujours à nouveau en plusieurs intervalles TR et est ainsi plusieurs fois mise en lecture,
plusieurs signaux étant générés également au sein d'un intervalle TR par une inversion multiple du gradient de lecture,
et les signaux de lectures plusieurs fois lus étant codés avec résolution locale à chaque fois de manière identique par l'utilisation de gradient de codage de phases et ne se différentiant, par conséquent, que pour ce qui est du déphasage donné par la fréquence de résonance correspondante, de telle sorte que les signaux individuels puissent être attribués par la suite, à chaque moment de lecture, aux contributions de signaux des substances examinées de fréquence différente,
**caractérisé en ce**
**que** les spins examinés sont préparés dans un état hyper polarisé très éloigné de la magnétisation d'équilibre, et en ce que les gradients sont utilisés de telle sorte que toutes les intégrales de gradients entre les impulsions haute fréquence successives sont nulles, et en ce que les impulsions haute fréquence présentent des angles de basculement proches de 180°, ce qui permet à une re-focalisation complète de se produire.

2. Procédé selon la revendication 1, **caractérisé en ce que** les intégrales de gradient entre deux des impulsions haute fréquence répétées périodiquement à l'intervalle TR dans le sens de la formation d'un écho de spin sont deux fois plus grandes que l'intégrale sur les gradients correspondants entre l'impulsion d'excitation et la première impulsion haute fréquence se produisant à la suite à l'intervalle TR/2 de la séquence périodique.

3. Procédé selon l'une quelconque des revendications précédentes, **caractérisé en ce qu'**en sus du gradient de lecture, l'on utilise, dans une direction perpendiculaire à celui-ci, un gradient de sélection de couches, qui conduit, en conjonction à une exécution de l'impulsion haute fréquence en tant qu'impulsion de sélection de couches, à une excitation et une re-focalisation du spin de seulement un volume partiel.

**4.** Procédé selon l'une quelconque des revendications précédentes, **caractérisé en ce que**, dans une autre direction supplémentaire de l'espace, l'on utilise un gradient de codage de phase conformément à la méthode du codage d'images selon le procédé de transformation de Fourier à 2 dimensions.

**5.** Procédé selon la revendication 4, **caractérisé en ce qu'**en sus, dans la direction du gradient de sélection de couches, l'on utilise un autre gradient de codage de phase supplémentaire, qui conduit à un codage à résolution locale des signaux conformément au procédé de la transformation de Fourier à trois dimensions.

**6.** Procédé selon l'une quelconque des revendications 1 à 3, **caractérisé en ce qu'**un codage à résolution locale a lieu selon le principe du procédé de la projection inversée filtrée.

**7.** Procédé selon l'une quelconque des revendications 1 à 3, **caractérisé en ce qu'**un codage à résolution locale a lieu selon le principe du procédé dit 'Spiral Imaging'.

Fig.1

Fig. 2A

Fig.2B

EP 1 574 874 B1

Fig.2C

TR/2 TR

TE1 TE2 TE3

90°
φ=0°

α,φ

α,φ

rf

TAQ1 TAQ2 TAQ3

S1

S4

S4

GS

S2

S3

S5

S5

R3

R5

GR

R2

R4

GP

n2

Fig.3

13

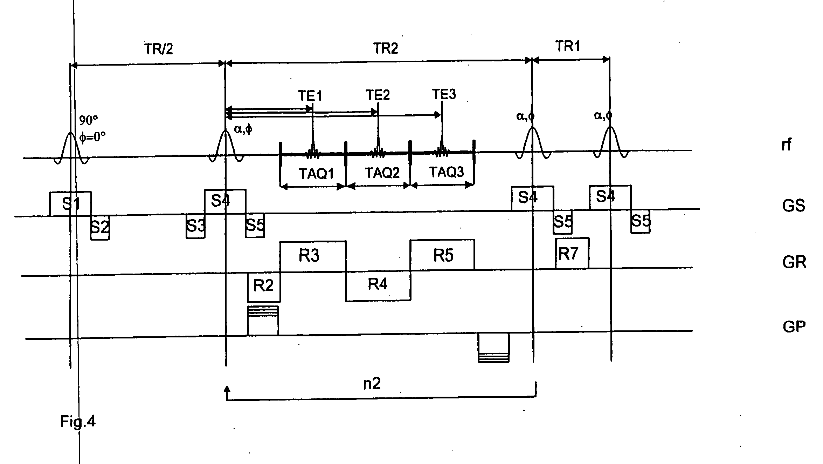

Fig.4

14

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur

- **CARR HY.** *Phys.Rev.,* 1958, vol. 112, 1693
- **HERZKA DA ; KELLMAN P ; ALETRAS AH ; GUTTMAN MA ; MCVEIGH ER.** Multishot EPI-SSFP in the heart. *Magn Reson Med,* 2002, vol. 47 (4), 655-664
- **FEINBERG, D. A. ; KIEFER, B. ; LITT, A. W.** Dual contrast GRASE (gradient-spin echo) imaging using mixed bandwidth. *Magnetic Resonance in Medicine,* 1994, vol. 31, 461-464
- **SARKAR S ; HEBERLEIN K ; METZGER GJ ; ZHANG X ; HU X.** Applications of highresolution echoplanar spectroscopic imaging for structural imaging. *J Magn Reson Imaging,* 1999, vol. 10 (1), 1-7
- **REEDER SB ; WEN Z ; YU H ; PINEDA AR ; GOLD GE ; MARKL M ; PELC NJ.** Multicoil Dixon chemical species separation with an iterative least-squares estimation method. *Magn Reson Med,* 2004, vol. 51 (1), 35-45
- **FEINBERG DA ; TURNER R ; JAKAB PD ; VON KIENLIN M.** Echo-planar imaging with asymmetric gradient modulation and inner-volume excitation. *Magn Reson Med,* 1990, vol. 13 (1), 162-169
- **HENNIG J ; WEIGEL M ; SCHEFFLER K.** Multiecho sequences with variable refocusing Flip Angles: Optimization of Signal Behavior using smooth Transitions between Pseudo Steady States (TRAPS. *Magnet Reson Med,* 2003, vol. 49 (3), 527-535
- **HENNIG J ; SPECK O ; SCHEFFLER K.** Optimization of the signal behavior in the transition to driven equilibrium in steady state free precession sequences. *Magnet Reson Med,* 2002, vol. 48 (5), 801-809
- **HENNIG J ; SCHEFFLER K.** *Hyperechoes, Magnet Reson Med,* 2001, vol. 46 (1), 6-12
- **DREHER W ; LEIBFRITZ D.** A New Method for Fast Proton Spectroscopic Imaging: Spetroscopic GRASE. *Magnet Reson Med,* 2000, vol. 44, 668-672
- **DAY I J ; WAIN R ; TOZAWA T ; SMITH L J ; HORE P J.** Photo-CIDNP NMR spectroscopy of a heme-containing protein. *Journal of Magnetic Resonance,* 2005, vol. 175, 330-335
- **MANSSON S ; JOHANSSON E ; MAGNUSSON P ; CHAI C-M ; HANSSON G ; PETERSSON J S ; STRAHLBERG F ; GOLMAN K.** C imaging - a new diagnostic platform. *Eur Radiol,* 2006, vol. 16, 57-67